# EUROPEAN PATENT APPLICATION

(11) **EP 4 407 698 A2**
(43) Date of publication of application: **31.07.2024**
(21) Application number: 24150960.3
(22) Date of filing: 09.01.2024
(51) Int. Cl.: H01L 33/04, H01L 33/08

(54) **INFRARED LED ELEMENT**

(30) Priority: 27.01.2023 JP 2023010762
(71) Applicant: Ushio Denki Kabushiki Kaisha, Tokyo 100-8150 (JP)
(72) Inventor: IIZUKA, Kazuyuki, Tokyo, 100-8150 (JP); SUGIYAMA, Toru, Tokyo, 100-8150 (JP)
(74) Representative: Maiwald GmbH

(57) **Abstract**

The infrared LED element (1) includes a first LED laminate (20) including a first cladding layer (21) of a first conductivity type, a first light-emitting layer (22), and a second cladding layer (23) of a second conductivity type; a laminate for tunnel junction (30) disposed directly or indirectly on top of the first LED laminate (20); and a second LED laminate (40) disposed directly or indirectly on top of the laminate for tunnel junction (30) and including a third cladding layer (41) of a first conductivity type, a second light-emitting layer (42), and a fourth cladding layer (43) of a second conductivity type. The laminate for tunnel junction (30) includes a first tunnel layer (31) containing a second conductivity-type dopant at a higher concentration than the second cladding layer; and a second tunnel layer (32) containing a first conductivity-type dopant at a higher concentration than the third cladding layer (41) and forming a tunnel junction with the first tunnel layer (31).

## Description

### BACKGROUND OF THE INVENTION

### Field of the Invention

The present invention relates to an infrared LED element and particularly relates to an infrared LED element having a peak emission wavelength of 1000 nm or more.

### Description of the Related Art

In recent years, semiconductor light-emitting elements having an emission wavelength in an infrared region of wavelengths of 1000 nm or more have been used for a wide variety of applications such as surveillance or monitoring cameras, gas detectors, medical sensors, and industrial equipment. Patent Document 1 mentioned below discloses an infrared LED element having a peak emission wavelength of 1000 nm or more and including a semiconductor layer lattice-matched to an InP crystal.

### PRIOR ART DOCUMENT

### Patent Document

Patent Document 1: JP-B2-6617218

### SUMMARY OF THE INVENTION

When an LED element is manufactured, the material of a semiconductor layer is selected from among materials having a band gap energy corresponding to a desired wavelength (target wavelength) of light from the LED element. Further, in order to use the selected material as a material of a light-emitting layer, a single crystal substrate is required that can be lattice-matched to the selected material and can industrially be manufactured, and the selected material itself is also required to be able to epitaxially grow with high quality on the single crystal substrate.

Due to such circumstances, the range of choices of the material of a semiconductor layer that can be used to achieve a target wavelength is actually narrow. When an infrared LED element having a peak emission wavelength of 1000 nm or more is manufactured, the material of a light-emitting layer is selected from among single-crystal materials that can be lattice-matched to an InP single crystal. Specifically, the material of a light-emitting layer may be one or two or more selected from the group consisting of GalnAsP, AIGalnAs, and GaInAs.

An LED element manufactured using such a light-emitting layer material as described above is inferior in light-emitting efficiency to LED elements in the other wavelength ranges because of the physical properties of the material. Particularly, when the amount of injected electric current is increased, light-emitting efficiency is further reduced and therefore it is difficult to obtain high output. The output of infrared light can be increased by arranging many LED elements, which, however, increases costs from an industrial viewpoint. For this reason, industry using LED elements having a peak emission wavelength of 1000 nm or more is difficult to progress.

In light of such circumstances, it is an object of the present invention to achieve an infrared LED element that has a peak emission wavelength of 1000 nm or more and improved optical output per LED element than ever before.

The present invention is directed to an infrared LED element having a peak emission wavelength of 1000 nm or more, the infrared LED element including:
a first LED laminate including a first cladding layer of a first conductivity type being p-type or n-type, a first light-emitting layer disposed directly or indirectly on top of the first cladding layer, and a second cladding layer of a second conductivity type different from the first conductivity type, the second cladding layer being disposed directly or indirectly on top of the first light-emitting layer;
a laminate for tunnel junction disposed directly or indirectly on top of the first LED laminate; and
a second LED laminate including a third cladding layer of the first conductivity type disposed directly or indirectly on top of the laminate for tunnel junction, a second light-emitting layer directly or indirectly disposed on top of the third cladding layer, and a fourth cladding layer of the second conductivity type disposed directly or indirectly on top of the second light-emitting layer,
wherein the laminate for tunnel junction includes:
   a first tunnel layer disposed directly or indirectly on top of the second cladding layer and containing a dopant of the second conductivity type at a higher concentration than the second cladding layer; and
   a second tunnel layer disposed directly or indirectly on top of the first tunnel layer and below the third cladding layer, containing a dopant of the first conductivity type at a higher concentration than the third cladding layer, and forming a tunnel junction with the first tunnel layer, and
   the first light-emitting layer, the second light-emitting layer, the first tunnel layer, and the second tunnel layer are made of a material that can be lattice-matched to an InP single crystal.

The "peak emission wavelength" herein refers to a wavelength at which optical output is highest in an emission spectrum.

In the infrared LED element, the multiple light-emitting layers are arranged in a direction in which the semiconductor layers are laminated (hereinafter sometimes referred to as "lamination direction"). Therefore, optical output is improved as compared to a conventional infrared LED element having a single light-emitting layer.

However, merely arranging the light-emitting layers in the lamination direction leads to the formation of a P-N junction plane, to which a reverse bias is applied, at the interface between any two layers present between the two light-emitting layers when a forward bias is applied to the light-emitting layers. As a result, electric current does not flow through the light-emitting layers or a drastic voltage increase occurs.

On the other hand, according to the above configuration, the laminate for tunnel junction is formed, in the lamination direction, between the first LED laminate including the first light-emitting layer and the second LED laminate including the second light-emitting layer. The laminate for tunnel junction includes the first tunnel layer disposed on the first LED laminate side and having the same second conductivity type as the second cladding layer of the first LED laminate and the second tunnel layer disposed on the second LED laminate side and having the same first conductivity type as the third cladding layer of the second LED laminate, and a tunnel junction is formed between the first tunnel layer and the second tunnel layer. That is, according to the above configuration, when a forward bias is applied between the first cladding layer and the fourth cladding layer, a forward bias is applied to each of the first LED laminate and the second LED laminate, and a voltage drop hardly occurs in an area sandwiched between the first LED laminate and the second LED laminate due to the tunnel junction. This makes it possible to provide a plurality of light-emitting layers in a single infrared LED element to improve optical output per unit element without causing a significant voltage drop.

When the first tunnel layer and the second tunnel layer are made of a material that can be lattice-matched to an InP single crystal as in the case of the first light-emitting layer and the second light-emitting layer, the infrared LED element can be manufactured without degrading the quality of each of the light-emitting layers. Specifically, the first tunnel layer and the second tunnel layer may be made of one or two or more selected from the group consisting of InP, GalnAsP, and AIGalnAs.

Further, the third cladding layer and the fourth cladding layer may also be made of a material that can be lattice-matched to an InP single crystal.

The first tunnel layer and the second tunnel layer may be made of a material having a band gap corresponding to a wavelength shorter than the peak emission wavelength.

Unlike a laser diode element whose light is mainly extracted through a cleaved surface, in the case of an LED element, light is mainly extracted in its lamination direction. Therefore, from the viewpoint of increasing the output of light extracted from the LED element, the first tunnel layer and the second tunnel layer are preferably transparent to light emitted from one or both of the first light-emitting layer and the second light-emitting layer. According to the above configuration, light emitted from one or both of the first light-emitting layer and the second light-emitting layer is prevented from being absorbed by one or both of the first tunnel layer and the second tunnel layer.

In the case of an infrared LED element having a peak emission wavelength of 1000 nm or more, a full width at half maximum may reach 100 nm or more. From such a viewpoint, a wavelength corresponding to a band gap of each of the first tunnel layer and the second tunnel layer is preferably shorter by 50 nm or more and is more preferably shorter by 100 nm or more than the peak emission wavelength.

The wavelength corresponding to a band gap of each of the first tunnel layer and the second tunnel layer can be changed by adjusting the composition ratio of a material constituting each of the layers. However, the adjusting is subjected to a restriction that the material can be lattice-matched to an InP single crystal.

At least one selected from the first tunnel layer and the second tunnel layer may be made of a material containing Ga and As.

As described above, the first tunnel layer and the second tunnel layer are both made of a material that can be lattice-matched to an InP single crystal. As a result of the present inventors' diligent research, it has been found that, compared to a case where the first tunnel layer and the second tunnel layer are both made of InP, the inclusion of Ga and As in one or both of the first and second tunnel layers can reduce an applied voltage (forward voltage) when the same amount of electric current is injected into the infrared LED element.

The first conductivity type may be an n-type, the second conductivity type may be a p-type, and a wavelength corresponding to a band gap of a material constituting the second tunnel layer may be longer than a wavelength corresponding to a band gap of a material constituting the first tunnel layer.

Such a configuration makes it possible to further reduce an applied voltage (forward voltage) at the time when the same amount of electric current is injected into the infrared LED element. This point will be described later in the section "DETAILED DESCRIPTION OF THE PREFERRED EMBODIMENTS".

There are some methods to make a wavelength corresponding to a band gap of a material constituting the second tunnel layer longer than a wavelength corresponding to a band gap of a material constituting the first tunnel layer. Specifically, there are a method in which a Ga composition of a material constituting the second tunnel layer is made higher than a Ga composition of a material constituting the first tunnel layer and a method in which an As composition of a material constituting the second tunnel layer is made higher than an As composition of a material constituting the first tunnel layer.

The first light-emitting layer and the second light-emitting layer may be made of materials different in composition and a peak wavelength of light generated by one of the first light-emitting layer and the second light-emitting layer, which is located closer to a light extraction surface, may be longer than that of light generated by the other light-emitting layer.

Such a configuration makes it possible to achieve a multipeak infrared LED element. When the peak wavelength of light generated by the light-emitting layer located closer to a light extraction surface is made longer than that of light generated by the other light-emitting layer, it is possible to prevent the light generated by the other light-emitting layer from being absorbed in the light-emitting layer located closer to the light extraction surface.

According to the present invention, it is possible to achieve an infrared LED element that has a peak emission wavelength of 1000 nm or more and improved optical output per LED element than ever before.

### BRIEF DESCRIPTION OF THE DRAWINGS

Fig. 1 is a cross-sectional view schematically showing a structure of an infrared LED element of a first embodiment;
Fig. 2 is a cross-sectional view for illustrating a step in a method for manufacturing the infrared LED element shown in Fig. 1;
Fig. 3 is a cross-sectional view schematically showing a structure of an infrared LED element of a second embodiment;
Fig. 4 is a cross-sectional view for illustrating a step in a method for manufacturing the infrared LED element shown in Fig. 2;
Fig. 5 is a cross-sectional view for illustrating a step in the method for manufacturing the infrared LED element shown in Fig. 2;
Fig. 6 is a cross-sectional view schematically showing a structure of an infrared LED element of a third embodiment;
Fig. 7 is a cross-sectional view for illustrating a step in a method for manufacturing the infrared LED element shown in Fig. 6;
Fig. 8 is a cross-sectional view for illustrating a step in the method for manufacturing the infrared LED element shown in Fig. 6;
Fig. 9 is a cross-sectional view for illustrating a step in the method for manufacturing the infrared LED element shown in Fig. 6;
Fig. 10 is a cross-sectional view schematically showing a structure of an infrared LED element of Comparative Example 1;
Fig. 11 is a graph showing electric current-optical output characteristics of infrared LED elements of Example 1 and Comparative Example 1;
Fig. 12 is a cross-sectional view schematically showing a structure of an infrared LED element of Comparative Example 2;
Fig. 13 is a graph showing electric current-optical output characteristics of infrared LED elements of Example 2 and Comparative Example 2;
Fig. 14A is a graph showing a trend of change in a forward voltage of the infrared LED element when a dopant concentration of a p-type first tunnel layer is changed; and
Fig. 14B is a graph showing a trend of change in a forward voltage of the infrared LED element when a dopant concentration of an n-type second tunnel layer is changed.

### DETAILED DESCRIPTION OF THE PREFERRED EMBODIMENTS

Embodiments of an infrared LED element according to the present invention will be described with reference to the drawings. The drawings referenced below merely show schematic illustrations, and the dimensional ratios on the drawings do not necessarily reflect the actual dimensional ratios. Further, the dimensional ratios are not necessarily the same between the drawings.

The expression "another layer Q2 is formed on top of a layer Q1" is herein intended to include a case in which the layer Q2 is formed on the surface of the layer Q1 with a thin film being interposed between them as well as a case in which the layer Q2 is formed directly on the surface of the layer Q1. It should be noted that the "thin film" herein can refer to a layer having a film thickness of 20 nm or less, preferably 10 nm or less. It should be noted that the signs Q1 and Q2 used in this paragraph are used as signs denoting general layers and do not appear in the drawings.

The expression "another layer Q2 is formed on top of a layer Q1" herein indicates a concept including a case in which the layer Q2 is located above the layer Q1 when the placement position of the infrared LED element is turned, and the "upper" direction is not limited by which direction the infrared LED element is placed.

The expression "GalnAsP" herein represents a mixed crystal composed of Ga, In, As, and P and is a simple description from which a composition ratio is omitted. The same applies to other expressions such as "AIGalnAs".

### [First Embodiment]

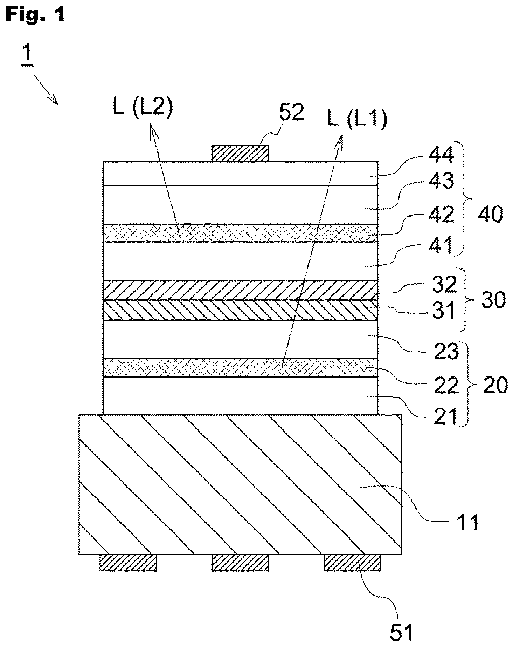

Fig. 1 is a cross-sectional view schematically showing a structure of an infrared LED element 1 of a first embodiment. The infrared LED element 1 includes a growth substrate 11, a first LED laminate 20, a laminate for tunnel junction 30, and a second LED laminate 40. Each of the first LED laminate 20, the laminate for tunnel junction 30, and the second LED laminate 40 is a laminate having a plurality of semiconductor layers. Each of the semiconductor layers is a layer formed on the growth substrate 11 by epitaxial growth.

The first LED laminate 20 has a first light-emitting layer 22, and the second LED laminate 40 has a second light-emitting layer 42. That is, the infrared LED element 1 emits light L1 generated by the first light-emitting layer 22 and light L2 generated by the second light-emitting layer 42. In other words, light (infrared light L) emitted from the infrared LED element 1 is superimposed light of the light L1 and the light L2. The infrared light L emitted from the infrared LED element 1 has a peak wavelength of 1000 nm or more.

### (Growth substrate 11)

The growth substrate 11 is a substrate made of an InP single crystal. In the present embodiment, the growth substrate 11 is of an n-type. Specifically, the growth substrate 11 may be an InP substrate doped with an n-type impurity (dopant). The n-type dopant material, with which the growth substrate 11 is doped, may be Sn, Si, S, Ge, Se, or the like and is particularly preferably Sn. The thickness of the growth substrate 11 is not limited, but is, for example, 20 µm to 1000 µm, preferably 50 µm to 700 µm. As an example, the growth substrate 11 is an InP single crystal substrate having a thickness of 250 µm and doped with Sn as a dopant material at a concentration of 1 × 10¹⁸/cm³.

### (First LED laminate 20)

The first LED laminate 20 includes a first cladding layer 21 constituted from a semiconductor layer of a first conductivity type, a first light-emitting layer 22 disposed on top of the first cladding layer 21, and a second cladding layer 23 disposed on top of the first light-emitting layer 22 and constituted from a semiconductor layer of a second conductivity type. Each of these layers 21, 22, and 23 is made of a material that can be lattice-matched to the InP single crystal constituting the growth substrate 11.

In the present embodiment, the first cladding layer 21 is an n-type semiconductor layer. That is, in the present embodiment, the "first conductivity type" is an n-type.

Specifically, the first cladding layer 21 is made of one or two or more selected from the group consisting of InP, GalnAsP, AIGalnAs, and AllnAs. The thickness of the first cladding layer 21 is not limited, but is, for example, 100 nm to 10000 nm, preferably 500 nm to 5000 nm. The concentration of an n-type dopant in the first cladding layer 21 is preferably 1 × 10¹⁷/cm³ to 5 × 10¹⁸/cm³, more preferably 5 × 10¹⁷/cm³to 4 × 10¹⁸/cm³. The n-type impurity material, with which the first cladding layer 21 is doped, may be Sn, Si, S, Ge, Se, or the like, and is particularly preferably Si.

As an example, the first cladding layer 21 has s thickness of 2000 nm and is made of n-type InP doped with Si as a dopant material at a concentration of 2 × 10¹⁸/cm³.

The material of the first light-emitting layer 22 is appropriately selected from materials that can generate light having a target wavelength and can be epitaxially grown and lattice-matched to the growth substrate 11. For example, the first light-emitting layer 22 may have a single-layer structure of GalnAsP, AIGalnAs, or GaInAs, or may have a multiple quantum well (MQW) structure that includes a well layer made of GalnAsP, AIGalnAs, or GaInAs and a barrier layer made of GalnAsP, AIGalnAs, GaInAs, or InP having a larger band gap energy than the well layer.

When having a single-layer structure, the first light-emitting layer 22 has a film thickness of 50 nm to 2000 nm, preferably 100 nm to 500 nm. When having an MQW structure, the first light-emitting layer 22 is formed by laminating a well layer and a barrier layer, each of which has a film thickness of 5 nm to 20 nm, in the range of 2 cycles to 50 cycles.

The first light-emitting layer 22 may be doped with an n-type or p-type dopant or may be undoped. When the first light-emitting layer 22 is doped with an n-type dopant, the dopant may be, for example, Si.

As an example, the first light-emitting layer 22 has a thickness of 300 nm and is made of undoped GalnAsP whose composition ratio has been adjusted to achieve a peak emission wavelength of 1300 nm.

In the present embodiment, the second cladding layer 23 is a p-type semiconductor layer. That is, in the present embodiment, the "second conductivity type" is a p-type.

Specifically, the second cladding layer 23 is made of one or two or more selected from the group consisting of InP, GalnAsP, AIGalnAs, and AllnAs. The thickness of the second cladding layer 23 is not limited, but is, for example, 1000 nm to 10000 nm, preferably 2000 nm to 5000 nm. The concentration of a p-type dopant in the second cladding layer 23 at a position away from the first light-emitting layer 22 is preferably 1 × 10¹⁷/cm³to 3 × 10¹⁸/cm³, more preferably 5 × 10¹⁷/cm³ to 3 × 10¹⁸/cm³.

The p-type dopant contained in the second cladding layer 23 may be Zn, Mg, Be, or the like, and is preferably Zn or Mg, particularly preferably Zn.

As an example, the second cladding layer 23 has a thickness of 1000 nm and is made of p-type InP doped with Zn as a dopant material at a concentration of 5 × 10¹⁷/cm³.

### (Laminate for tunnel junction 30)

The laminate for tunnel junction 30 is located on top of the first LED laminate 20, and includes a first tunnel layer 31 constituted from a semiconductor layer of a second conductivity type and a second tunnel layer 32 disposed on top of the first tunnel layer 31 and constituted from a semiconductor layer of a first conductivity type. At the interface between the first tunnel layer 31 and the second tunnel layer 32, a tunnel junction is formed.

In the present embodiment, the first tunnel layer 31 is a p-type semiconductor layer. Specifically, the first tunnel layer 31 is made of one or two or more selected from the group consisting of InP, GalnAsP, and AIGalnAs.

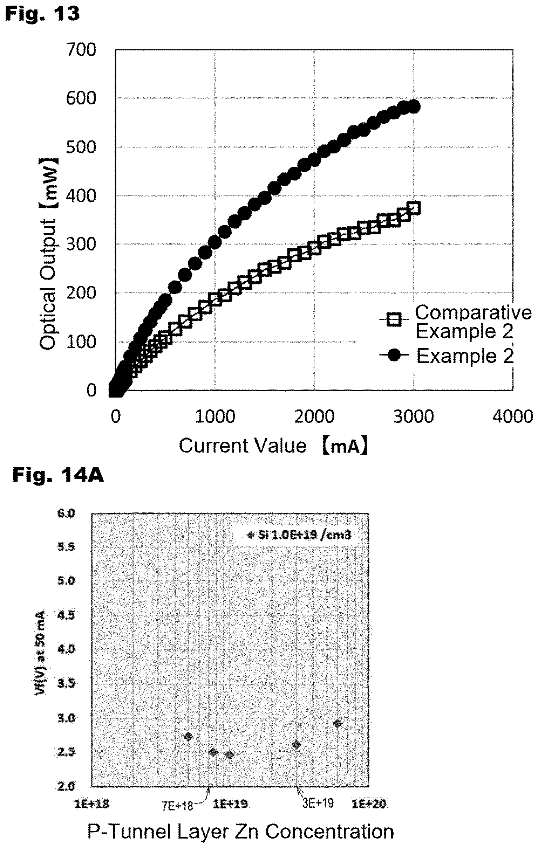

The concentration of a p-type dopant in the first tunnel layer 31 is higher than that in the second cladding layer 23 and is preferably 1 × 10¹⁸/cm³ to 1 × 10²⁰/cm³, more preferably 5 × 10¹⁸/cm³ to 5 × 10¹⁹/cm³. As will be described later with reference to Fig. 14A, the effect of reducing a forward bias at the time of injection of the same amount of electric current becomes conspicuous by setting the p-type dopant concentration of the first tunnel layer 31 to 7 × 10¹⁸/cm³ to 3 × 10¹⁹/cm³.

In the present embodiment, the second tunnel layer 32 is an n-type semiconductor layer. Specifically, the second tunnel layer 32 is made of one or two or more selected from the group consisting of InP, GalnAsP, and AIGalnAs.

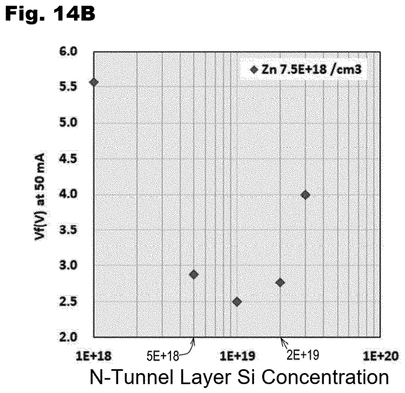

The concentration of an n-type dopant in the second tunnel layer 32 is higher than that in a third cladding layer 41 which will be described later and is preferably 1 × 10¹⁸/cm³ to 1 × 10²⁰/cm³, more preferably 1 × 10¹⁸/cm³ to 2 × 10¹⁹/cm³. As will be described later with reference to Fig. 14B, the effect of reducing a forward bias at the time of injection of the same amount of electric current becomes conspicuous by setting the n-type dopant concentration of the second tunnel layer 32 to 5 × 10¹⁸/cm³ to 2 × 10¹⁹/cm³.

In the present invention, the film thicknesses of the first tunnel layer 31 and the second tunnel layer 32 are not limited. However, if the film thicknesses of the first tunnel layer 31 and the second tunnel layer 32 are too small, there is a possibility that a necessary doping amount for achieving a tunnel junction at the tunnel junction interface cannot be obtained during crystal growth due to doping delay so that the forward voltage of a resulting infrared LED element increases. On the other hand, if the film thicknesses of the first tunnel layer 31 and the second tunnel layer 32 are too large, thick semiconductor layers doped at an extremely high concentration are grown, and therefore there is a fear that crystallinity reduces and thus the quality of the second light-emitting layer 42 that will be grown thereafter reduces so that light-emitting efficiency reduces. From such a viewpoint, the thicknesses of the first tunnel layer 31 and the second tunnel layer 32 are preferably 5 nm to 500 nm, particularly preferably 10 nm to 200 nm.

The first tunnel layer 31 and the second tunnel layer 32 are preferably made of a material having a band gap corresponding to a wavelength shorter than the peak wavelength of the infrared light L emitted from the infrared LED element 1. When the first tunnel layer 31 and the second tunnel layer 32 are made of such a material, it is possible to prevent light generated by the first light-emitting layer 22 and/or the second light-emitting layer 42 from being absorbed in the first tunnel layer 31 and the second tunnel layer 32.

The wavelength corresponding to a band gap of a material constituting each of the first tunnel layer 31 and the second tunnel layer 32 can be set by adjusting the composition ratio of the material. For example, GalnAsP lattice-matched to an InP single crystal can be achieved by adjusting the ratio between III-group elements (In, Ga) and V-group elements (As, P) to 50%. Here, when the Ga composition is reduced, a band gap energy increases so that the wavelength corresponding to a band gap shifts to the short wavelength side. In order to be lattice-matched to an InP single crystal, the As composition needs to be reduced while the Ga composition in GalnAsP is reduced.

The infrared light L emitted from the infrared LED element 1 and having a peak wavelength of 1000 nm or more may have a full width at half maximum of 100 nm or more in an emission spectrum. From such a viewpoint, the wavelength corresponding to a band gap of a material constituting each of the first tunnel layer 31 and the second tunnel layer 32 is preferably shorter by 50 nm or more and is more preferably shorter by 100 nm or more than the peak wavelength of the infrared light L emitted from the infrared LED element 1.

Further, at least one selected from the first tunnel layer 31 and the second tunnel layer 32 preferably contains Ga and As to the extent that it can be lattice-matched to InP. Such a configuration makes it possible to obtain the effect of reducing a forward bias voltage.

As an example, the first tunnel layer 31 has a thickness of 100 nm and is made of p-type InP doped with Zn as a dopant material at a concentration of 1 × 10¹⁹/cm³. As an example, the second tunnel layer 32 has a thickness of 100 nm and is made of n-type GaInAsP (which has a band gap corresponding to a wavelength of 1100 nm) doped with Si as a dopant material at a concentration of 1 × 10¹⁹/cm³.

### (Second LED laminate 40)

The second LED laminate 40 is located on top of the laminate for tunnel junction 30 and includes a third cladding layer 41 constituted from a semiconductor layer of a first conductivity type, a second light-emitting layer 42 disposed on top of the third cladding layer 41, a fourth cladding layer 43 disposed on top of the second light-emitting layer 42 and constituted from a semiconductor layer of a second conductivity type, and a contact layer 44 formed on top of the fourth cladding layer 43. Among these layers, at least the third cladding layer 41 and the second light-emitting layer 42 are made of a material that can be lattice-matched to the InP single crystal constituting the growth substrate 11.

Similarly to the first cladding layer 21, the third cladding layer 41 is an n-type semiconductor layer. Preferred conditions about the material, film thickness, dopant concentration, and dopant material of the third cladding layer 41 are the same as those of the first cladding layer 21. That is, the n-type dopant concentration of the third cladding layer 41 is lower than that of the second tunnel layer 32 disposed below the third cladding layer 41. As an example, the third cladding layer 41 has a thickness of 2000 nm and is made of n-type InP doped with Si as a dopant material at a concentration of 2 × 10¹⁸/cm³.

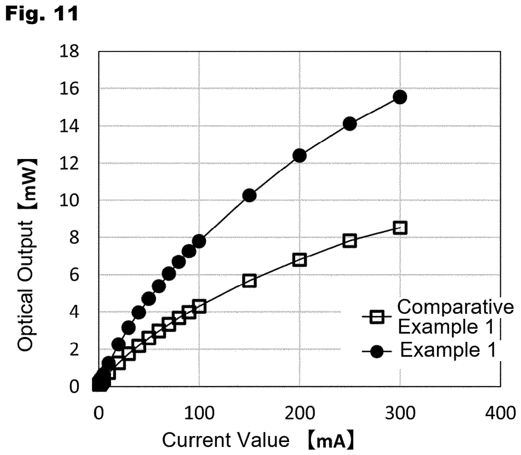

Preferred conditions for the material, film thickness, and the like of the second light-emitting layer 42 are the same as those of the first light-emitting layer 22. The material of the first light-emitting layer 22 and the material of the second light-emitting layer 42 may be the same or different in composition. In the former case, the infrared LED element 1 emits light L having a single peak wavelength, and in the latter case, the infrared LED element 1 emits light L having multiple peak wavelengths. In either case, optical output improves as compared to a conventional configuration having a single light-emitting layer. This point will be described later with reference to Fig. 11.

As an example, the second light-emitting layer 42 has a thickness of 300 nm and is made of undoped GalnAsP whose composition ratio has been adjusted to achieve a peak emission wavelength of 1300 nm.

It should be noted that when the infrared light L has multiple peaks, a wavelength corresponding to a band gap of a material constituting each of the first tunnel layer 31 and the second tunnel layer 32 is preferably shorter than the shorter of the peak wavelengths of the light L1 and the peak wavelength of the light L2.

Further, when the infrared light L has multiple peaks, the peak wavelength of light generated by one of the first light-emitting layer 22 and the second light-emitting layer 42, which is located closer to the surface (light extraction surface) of the infrared LED element 1 from which the light L is extracted, is preferably longer than the peak wavelength of light generated by the light-emitting layer located away from the light extraction surface. In the example shown in Fig. 1, the surface located on the side opposite to the growth substrate 11 is designed as a light extraction surface. Specifically, the second light-emitting layer 42 is located close to the light extraction surface, and the first light-emitting layer 22 is located away from the light extraction surface. In this case, the material of the first light-emitting layer 22 and the material of the second light-emitting layer 42 are preferably set so that the peak wavelength of light L2 generated by the second light-emitting layer 42 is longer than the peak wavelength of light L1 generated by the first light-emitting layer 22. Such a configuration makes it possible to prevent the light L1 generated by the first light-emitting layer 22 from being absorbed in the second light-emitting layer 42.

As an example, when both the first light-emitting layer 22 and the second light-emitting layer 42 are made of a GalnAsP-based material, the Ga composition and the As composition of the second light-emitting layer 42 can be made higher than those of the first light-emitting layer 22. As another example, when both the first light-emitting layer 22 and the second light-emitting layer 42 are made of an AIGalnAs-based material, the Ga composition of the second light-emitting layer 42 can be made higher than that of the first light-emitting layer 22.

Specifically, when the second light-emitting layer 42 is made of Ga_{0.44}In_{0.56}As_{0.94}P_{0.06} and the first light-emitting layer 22 is made of Ga_{0.28}In_{0.72}As_{0.61}P_{0.39}, the second light-emitting layer 42 emits light L2 having a wavelength of 1550 nm and the first light-emitting layer 22 emits light L1 having a wavelength of 1300 nm. From the light extraction surface of the infrared LED element 1, superimposed light L of the light L1 and the light L2 is emitted.

Preferred conditions about the material, film thickness, and the like of the fourth cladding layer 43 are the same as those of the second cladding layer 23. However, when two light-emitting layers are provided as in the case of the infrared LED element 1 shown in Fig. 1, the light-emitting layers are not formed after the fourth cladding layer 43 is formed during manufacturing. In other words, even when the fourth cladding layer 43 and the contact layer 44 are made of a material that is not lattice-matched to an InP single crystal, the film quality of the light-emitting layers is not affected thereby. Therefore, the fourth cladding layer 43 and the contact layer 44 may be made of a material that is not lattice-matched to an InP single crystal. Specifically, the fourth cladding layer 43 and the contact layer 44 can be made of one or two or more selected from the group consisting of InP, GalnAsP, AIGalnAs, GaInAs, AlGaAs, and GaAs.

As an example, the fourth cladding layer 43 has a thickness of 3000 nm and is made of p-type InP doped with Zn as a dopant material at a concentration of 5 × 10¹⁷/cm³.

The contact layer 44 is a semiconductor layer provided to achieve an electrical connection between the p-type semiconductor layer and an electrode 52. The thickness of the contact layer 44 is not limited, but is, for example, 10 nm to 1000 nm, preferably 50 nm to 500 nm. The concentration of a p-type dopant in the contact layer 44 is preferably 5 × 10¹⁷/cm³ to 3 × 10¹⁹/cm³, more preferably 1 × 10¹⁸/cm³ to 2 × 10¹⁹/cm³.

As an example, the contact layer 44 has a thickness of 200 nm and is made of p-type GaInAsP (which has a band gap corresponding to a wavelength of 1100 nm) doped with Zn as a dopant material at a concentration of 2 × 10¹⁸/cm³.

The infrared LED element 1 includes an electrode 51. The electrode 51 is disposed on the back surface side of the growth substrate 11 (on the side opposite to the side where the semiconductor layers are formed). In this embodiment, the electrode 51 constitutes an n-side electrode. Between the electrode 51 and the growth substrate 11 made of n-type InP, an ohmic contact is formed. The electrode 51 is made of, for example, a material such as Au/Ge/Au, Au/Ge/Ni/Au, AuGe, or Au-GeNi, and may contain two or more of these materials. The thickness of electrode 51 is not limited, but is, for example, 50 nm to 500 nm, preferably 100 nm to 300 nm.

The infrared LED element 1 includes an electrode 52. The electrode 52 is disposed on the top surface of the contact layer 44. In the present embodiment, the electrode 52 constitutes a p-side electrode. The electrode 52 is made of a material that can form an ohmic contact with the contact layer 44 constituted from a p-type semiconductor layer. The electrode 52 is made of, for example, a material such as Au/Zn/Au, AuZn, or AuBe, and may contain two or more of these materials. The thickness of electrode 52 is not limited, but is, for example, 50 nm to 500 nm, preferably 100 nm to 300 nm.

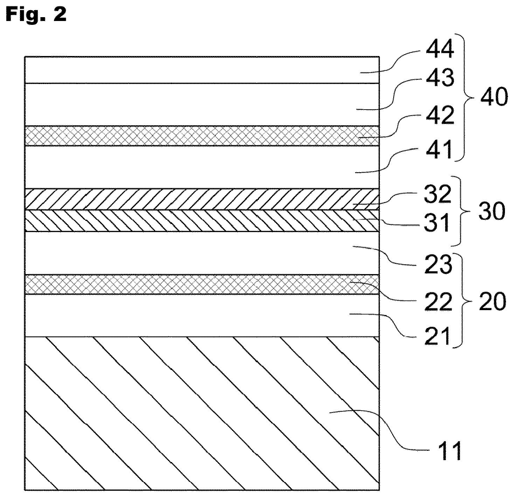

When the infrared LED element 1 is manufactured, the growth substrate 11 made of n-type InP is conveyed into a metal-organic chemical vapor deposition (MOCVD) apparatus, and the above-described semiconductor layers (21, 22, 23, 31, 32, 41, 42, 43, 44) are epitaxially grown in order on the growth substrate 11 to form the laminates (20, 30, 40) (see Fig. 2). The type and flow rate of a raw material gas, processing time, environmental temperature, and the like. are appropriately adjusted depending on the material and film thickness of a layer to be grown. Examples of materials of the semiconductor layers (21, 22, 23, 31, 32, 41, 42, 43, 44) are as described above.

Then, mesa etching for separation into elements is performed, and the electrodes (51, 52) are then formed to obtain the infrared LED element 1 shown in Fig. 1.

When the infrared LED element 1 is turned on, a forward bias is applied between the electrode 51 and the electrode 52. Specifically, a voltage is applied so that the electrode 52 is at a positive electric potential and the electrode 51 is at a negative electric potential. In the infrared LED element 1, the LED laminates (20, 40) are arranged in series in the lamination direction with the laminate for tunnel junction 30 being interposed between them. Therefore, even when the n-type layer (third cladding layer 41) of the second LED laminate 40 and the p-type layer (second cladding layer 23) of the first LED laminate 20 are arranged along a direction in which electric current flows, electric current is allowed to flow under low-resistance conditions through the tunnel junction formed in the laminate for tunnel junction 30 interposed between them. Further, as shown in Fig. 1, the infrared LED element 1 includes a plurality of light-emitting layers (22, 42). Therefore, as compared to a conventional configuration including a single light-emitting layer, the infrared LED element 1 can improve optical output without causing a significant increase in voltage.

### [Second Embodiment]

A second embodiment of the infrared LED element according to the present invention will be described by mainly focusing on differences from the first embodiment. It should be noted that components common to those of the first embodiment will be denoted by the same reference numerals, and the description thereof will be omitted as appropriate.

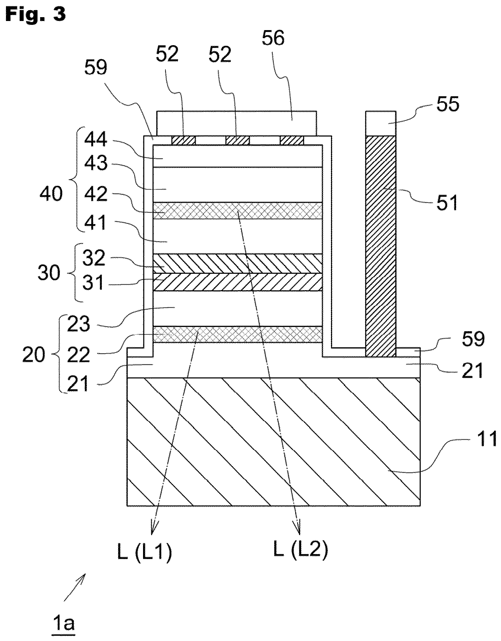

Fig. 3 is a cross-sectional view schematically showing a structure of an infrared LED element 1a of the present embodiment. Similarly to the infrared LED element 1 of the first embodiment, the infrared LED element 1a shown in Fig. 3 includes a growth substrate 11, a first LED laminate 20, a laminate for tunnel junction 30, and a second LED laminate 40.

Unlike the infrared LED element 1 of the first embodiment, the infrared LED element 1a of the present embodiment is designed to extract light L from the growth substrate 11 side. The infrared LED element 1a includes pad electrodes (55, 56) and an insulating layer 59.

The insulating layer 59 is disposed to cover the top surfaces and side surfaces of semiconductor layers (21, 22, 23, 31, 32, 41, 42, 43, 44), and electrodes (51, 52) are formed to penetrate part of the insulating layer 59. When the peak wavelength of the infrared light L is 1000 nm or more, the insulating layer 59 can be made of a material such as SiO₂, SiN, Al₂O₃, or AIN.

In part of the first cladding layer 21, the semiconductor layers (22, 23, 31, 32, 41, 42, 43, 44) formed on top of the first cladding layer 21 are removed. In such a part, the first cladding layer 21 forms an ohmic contact with the electrode 51 formed to penetrate the insulating layer 59. The contact layer 44 forms an ohmic contact with the electrode 52 formed to penetrate part of the insulating layer 59.

On the top surface of the electrode 51, the n-side pad electrode 55 is formed. On the top surface of the electrode 52, the p-side pad electrode 56 is formed. A bonding wire, a bonding ball, or the like (not shown) for power feeding is in contact with each of the pad electrodes (55, 56). The pad electrodes (55, 56) are made of, for example, Ti/Au or Ti/Pt/Au.

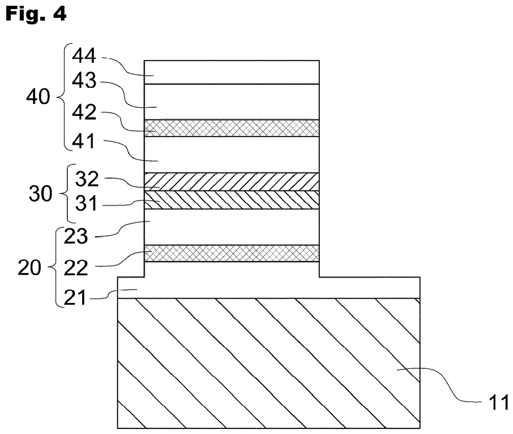

When the infrared LED element 1a of the present embodiment is manufactured, the semiconductor layers in a state shown in Fig. 2 are partially removed by etching so that the first cladding layer 21 is exposed (see Fig. 4). Then, the insulating layer 59 is formed on the entire surface of the semiconductor laminates by plasma CVD. As an example, the insulating layer 59 made of SiO₂ is formed to have a film thickness of 200 nm.

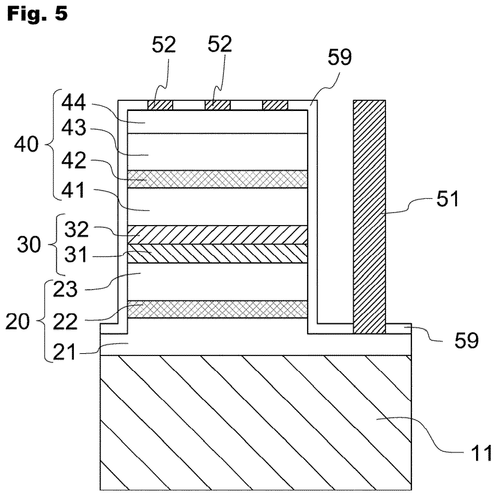

Then, the electrodes (51, 52) are formed using a technique of photolithography and etching (see Fig. 5). At this time, annealing treatment is performed, if necessary. Then, a metallic material is evaporated onto the top surface of each of the electrodes (51, 52) to form the pad electrodes (55, 56).

It should be noted that as shown in Fig. 3, in the case of the infrared LED element 1a of the present embodiment, the first light-emitting layer 22 is located close to the light extraction surface, and the second light-emitting layer 42 is located away from the light extraction surface. Therefore, when the infrared LED element 1a is achieved to emit infrared light L with multiple peaks, unlike the first embodiment, the material of the first light-emitting layer 22 and the material of the second light-emitting layer 42 are preferably set so that the peak wavelength of light L1 generated by the first light-emitting layer 22 is longer than the peak wavelength of light L2 generated by the second light-emitting layer 42. Such a configuration makes it possible to prevent the light L2 generated by the second light-emitting layer 42 from being absorbed in the first light-emitting layer 22.

The description of the second embodiment other than the above is the same as that of the first embodiment and is therefore omitted.

### [Third Embodiment]

A third embodiment of the infrared LED element according to the present invention will be described by mainly focusing on differences from the first embodiment. It should be noted that components common to those of the first embodiment will be denoted by the same reference numerals, and the description thereof will be omitted as appropriate.

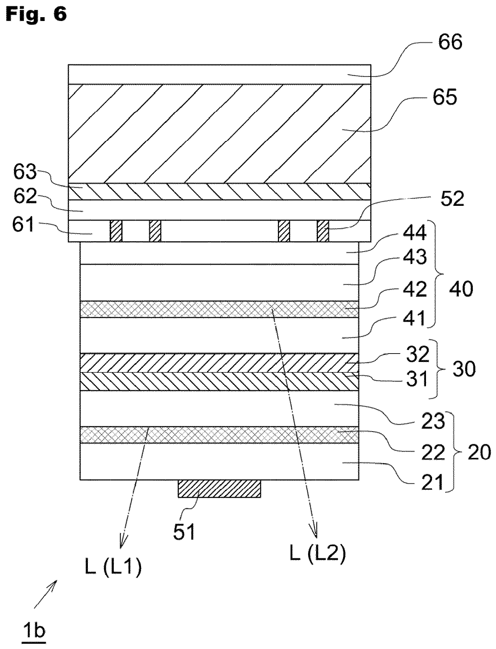

Fig. 6 is a cross-sectional view schematically showing a structure of an infrared LED element 1b of the present embodiment. Similarly to the infrared LED element 1 of the first embodiment, the infrared LED element 1b shown in Fig. 6 includes a first LED laminate 20, a laminate for tunnel junction 30, and a second LED laminate 40.

Unlike the infrared LED element 1 of the first embodiment, the infrared LED element 1b of the present embodiment is designed to extract light L from the first LED laminate 20 side (first cladding layer 21 side).

Unlike the infrared LED element 1 of the first embodiment, the infrared LED element 1b of the present embodiment includes a support substrate 65 instead of the growth substrate 11. The support substrate 65 is an electrically-conductive substrate. The support substrate 65 is made of, for example, a semiconductor such as Si or Ge or a metallic material such as Cu or CuW. When made of a semiconductor, the support substrate 65 may be doped with a dopant at a high concentration so as to have electrical conductivity. As an example, the support substrate 65 is a Si substrate doped with boron (B) at a dopant concentration of 1 × 10¹⁹/cm³ or more and having a resistivity of 10 Qcm or less. It should be noted that the growth substrate 11 is used for epitaxially growing semiconductor layers (21, 22, 23, 31, 32, 41, 42, 43, 44) as in the case of the infrared LED element 1 of the first embodiment, but in the present embodiment, the growth substrate 11 is removed in a subsequent step.

The infrared LED element 1b of the present embodiment includes an insulating layer 61, a reflecting layer 62, and a bonding layer 63.

The insulating layer 61 is made of an electrically insulating material highly transparent to the infrared light L. When the peak wavelength of the infrared light L is 1000 nm or more, the insulating layer 61 can be made of a material such as SiO₂, SiN, Al₂O₃, or AIN.

The reflecting layer 62 performs the function of reflecting part of light L1 that travels to the support substrate 65 side out of the light L1 generated in the first light-emitting layer 22 and light L2 generated in the second light-emitting layer 42, and leading such light to the light extraction surface side (first cladding layer 21 side). The reflecting layer 62 is made of an electrically conductive material that has a high reflectance for the infrared light L (light L1, light L2). The reflectance of the reflecting layer 62 for the infrared light L is preferably 70% or more, more preferably 80% or more, particularly preferably 90% or more. When the peak wavelength of the infrared light L is 1000 nm or more, the reflecting layer 62 can be made of a metallic material such as Ag, an Ag alloy, Au, Al, or Cu. The thickness of the reflecting layer 62 is not limited, but is, for example, 0.1 µm to 2.0 µm, preferably 0.3 µm to 1.0 µm. However, the infrared LED element 1b may not always include the reflecting layer 62.

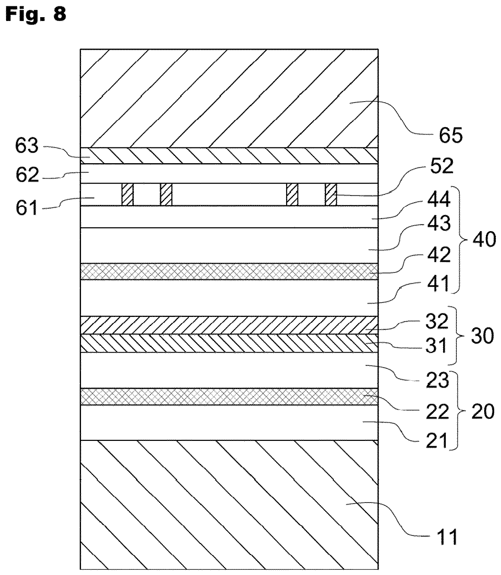

The bonding layer 63 is made of a low-melting solder material such as Au, Au-Zn, Au-Sn, Au-In, Au-Cu-Sn, Cu-Sn, Pd-Sn, or Sn. As will be described later with reference to Fig. 8, the bonding layer 63 is used to bond together the support substrate 65 and the growth substrate 11 on which the semiconductor laminates are formed. The thickness of the bonding layer 63 is not limited, but is, for example, 500 nm to 5000 nm, preferably 1000 nm to 3000 nm.

Although not shown in Fig. 6, a layer (solder diffusion prevention layer) may be further included between the reflecting layer 62 and the bonding layer 63 to prevent diffusion of the solder material constituting the bonding layer 63. The solder diffusion prevention layer can be made of, for example, a material containing Ti, Pt, W, Mo, Ni, or the like. As an example, the solder diffusion prevention layer is constituted from a laminate of Ti/Pt/Au. The thickness of the solder diffusion prevention layer is not limited, but is, for example, 50 nm to 3000 nm, preferably 200 nm to 1000 nm. The solder diffusion prevention layer interposed between the reflecting layer 62 and the bonding layer 63 makes it possible to prevent a reduction in the reflectance of the reflecting layer 62 due to diffusion of the material of the bonding layer 63 into the reflecting layer 62. The solder diffusion prevention layer may be provided also between the bonding layer 63 and the support substrate 65.

From the viewpoint of improving light extraction efficiency, the infrared LED element 1b preferably includes the reflecting layer 62 as shown in Fig. 6. However, in the present invention, providing the reflecting layer 62 in the infrared LED element 1b is optional.

The infrared LED element 1b of the present embodiment includes a back electrode 66 on the back surface side of the support substrate 65 (on the side opposite the side where the semiconductor layers are formed). The back electrode 66 forms an ohmic contact with the support substrate 65. The back electrode 66 is made of, for example, a material such as Ti/Au or Ti/Pt/Au, and may contain two or more of these materials.

Electrodes 52 penetrate part of the insulating layer 61 and electrically connect the contact layer 44 and the reflecting layer 62. It should be noted that the reflecting layer 62 and the bonding layer 63 are both electrically conductive layers. It should be noted that as shown in Fig. 6, the electrodes 52 are preferably discretely disposed in a direction parallel to the principal surfaces of the semiconductor layers. Further, electrodes 52 and electrode 51 are preferably disposed so as not to overlap each other in the normal direction of the principal surfaces of the semiconductor layers. This makes it possible to spread electric current flowing through the light-emitting layers (22, 42) in a direction parallel to the principal surfaces of the semiconductor layers and therefore to improve light-emitting efficiency.

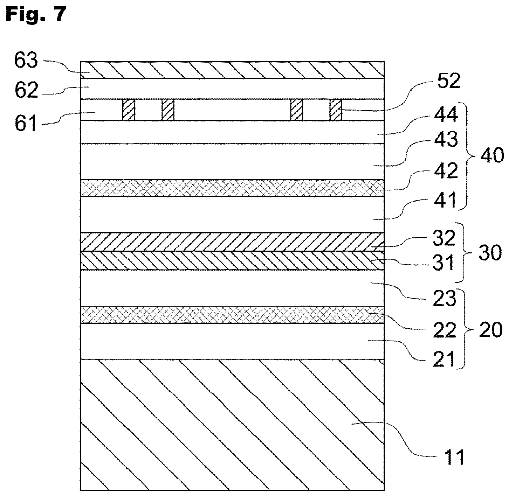

When the infrared LED element 1b of the present embodiment is manufactured, the electrodes 52, the insulating layer 61, the reflecting layer 62, and the bonding layer 63 are formed in order from a state shown in Fig. 2 (see Fig. 7). Specifically, a patterned resist mask is formed on the surface of the contact layer 44 by photolithography, a film is formed using material for forming the electrodes 52 (e.g., AuZn) with the use of a vacuum evaporation system, and the resist mask is removed by liftoff. Then, alloy treatment (annealing treatment) is performed by, for example, heating treatment at 450°C for 10 minutes to achieve an ohmic contact between the contact layer 44 and the electrodes 52.

Then, the insulating layer 61 is formed by plasma CVD, and part of the insulating layer 61 located on top of the electrodes 52 is then removed by photolithography and etching so that the electrodes 52 are exposed. Then, the reflecting layer 62 is formed by evaporating a metallic material in such a manner that the insulating layer 61 and the electrodes 52 are covered, and then the bonding layer 63 is formed by evaporating a metallic material.

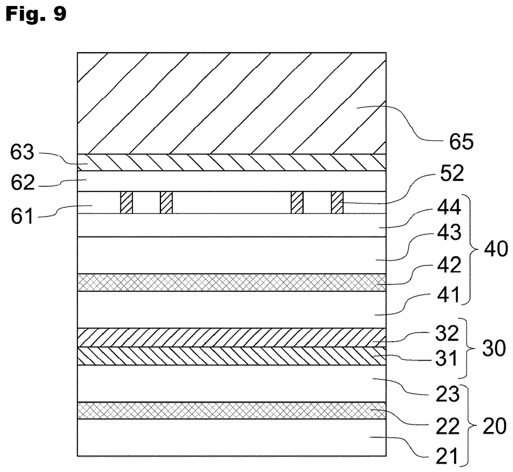

Then, as shown in Fig. 8, the support substrate 65 different from the growth substrate 11 is prepared, and the growth substrate 11 and the support substrate 65 are bonded together with the bonding layer 63 being interposed between them under conditions of, for example, a temperature of 280°C and a pressure of 1 MPa. Then, the growth substrate 11 is removed by subjecting the growth substrate 11 to grinding/polishing or wet etching using a hydrochloric acid-based etchant (see Fig. 9).

Then, the epitaxial wafer is subjected to mesa etching for separation into elements, and then the electrode 51 is formed on the top surface of the first cladding layer 21 and the back electrode 66 is formed on the back surface of the support substrate 65 (see Fig. 6).

In the infrared LED element 1b of the present embodiment, the first light-emitting layer 22 is located close to the light extraction surface and the second light-emitting layer 42 is located away from the light extraction surface as in the case of the infrared LED element 1a of the second embodiment. Therefore, when the infrared LED element 1b is achieved to emit infrared light L with multiple peaks, unlike the first embodiment, the material of the first light-emitting layer 22 and the material of the second light-emitting layer 42 are preferably set so that the peak wavelength of light L1 generated by the first light-emitting layer 22 is longer than the peak wavelength of light L2 generated by the second light-emitting layer 42. Such a configuration makes it possible to prevent the light L2 generated by the second light-emitting layer 42 from being absorbed in the first light-emitting layer 22.

The description of the third embodiment other than the above is the same as that of the first embodiment and is therefore omitted.

### [Other embodiments]

The infrared LED elements 1, 1a, and 1b may each include three or more LED laminates. In this case, the infrared LED elements 1, 1a, and 1b may each include two or more laminates for tunnel junction.

### [Verification]

The following Verification 1 to Verification 3 were performed on the infrared LED elements of the embodiments described above.

### (Verification 1)

Optical output was compared between a conventional infrared LED element having a single light-emitting layer and the infrared LED element according to the present invention.

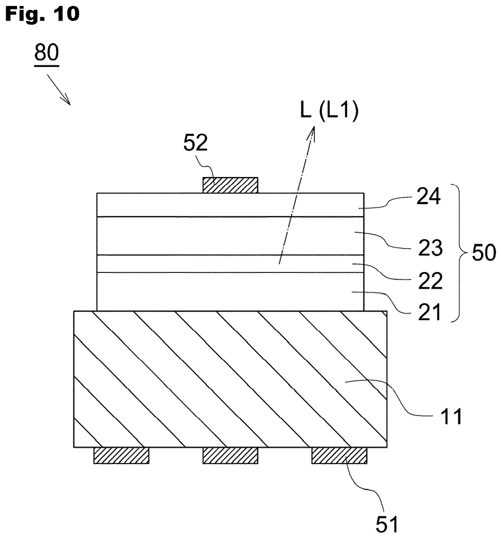

As an element of Example 1, the infrared LED element 1 described above with reference to the first embodiment was used. As an element of Comparative Example 1, an infrared LED element 80 shown in Fig. 10 was used. The infrared LED element 80 is different from the infrared LED element 1 in that it has a single LED laminate 50.

Specifically, the infrared LED element 80 includes a first cladding layer 21, a first light-emitting layer 22, a second cladding layer 23, and a contact layer 24. The film thicknesses, compositions, dopant materials, and dopant concentrations of the first cladding layer 21, the first light-emitting layer 22, the second cladding layer 23, and the contact layer 24 of the infrared LED element 80 were the same as those of the first cladding layer 21, the first light-emitting layer 22, the second cladding layer 23, and the contact layer 44 of the infrared LED element 1. The conditions of other components of the infrared LED element 80 were also the same as those of the infrared LED element 1. As details about the film thickness, composition, dopant material, and dopant concentration of each of the layers, values mentioned above as examples with reference to the first embodiment were used.

Fig. 11 is a graph obtained by plotting a relationship between the amount of injected electric current and optical output when each of the infrared LED element of Example 1 and the infrared LED element of Comparative Example 1 is turned on by injecting electric current. The optical output was measured using an integrating sphere method based on the amount of infrared light L received by a light-receiving sensor. As can be seen from Fig. 11, the optical output of the element of Example 1 is nearly twice that of the element of Comparative Example 1.

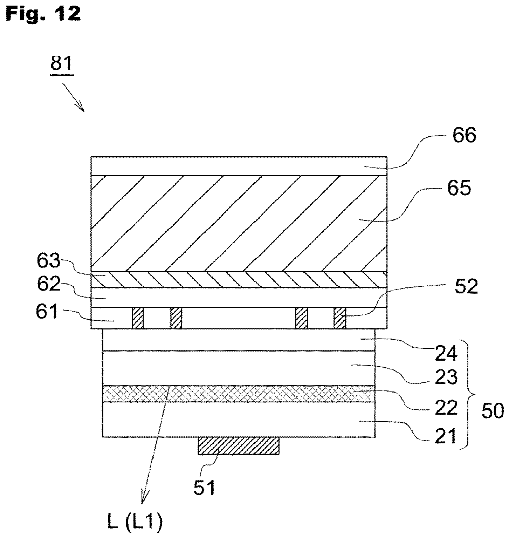

Then, the same verification was performed by using the infrared LED element 1b described above with reference to the third embodiment as an element of Example 2 and an infrared LED element 81 shown in Fig. 12 as an element of Comparative Example 2. The infrared LED element 81 is different from the infrared LED element 1b in that it has a single LED laminate 50.

Specifically, the infrared LED element 81 includes a first cladding layer 21, a first light-emitting layer 22, a second cladding layer 23, and a contact layer 24. The film thicknesses, compositions, dopant materials, and dopant concentrations of the first cladding layer 21, the first light-emitting layer 22, the second cladding layer 23, and the contact layer 24 of the infrared LED element 81 were the same as those of the first cladding layer 21, the first light-emitting layer 22, the second cladding layer 23, and the contact layer 44 of the infrared LED element 1b. The conditions of other components of the infrared LED element 81 were also the same as those of the infrared LED element 1b. As details about the film thickness, composition, dopant material, and dopant concentration of each of the layers, the same values as the elements of Example 1 and Comparative Example 1 were used.

Fig. 13 is a graph obtained by plotting a relationship between the amount of injected electric current and optical output when each of the infrared LED element of Example 2 and the infrared LED element of Comparative Example 2 is turned on by injecting electric current. The optical output was measured using an integrating sphere method based on the amount of infrared light L received by a light-receiving sensor. As can be seen from Fig. 13, the optical output of the element of Example 2 is nearly twice that of the element of Comparative Example 2.

As described above, semiconductor layers constituting the first tunnel layer 31 and the second tunnel layer 32 (laminate for tunnel junction 30), which form a tunnel junction, need to be doped with an impurity material at a high concentration. However, when a semiconductor layer is doped with an impurity material at a high concentration, the maximum dopant concentration of the semiconductor layer that can actually be doped depends on the semiconductor material, even if the impurity material for doping is simply supplied in large amounts during crystal growth of the relevant semiconductor layer. Further, high-concentration doping will degrade the quality of the semiconductor crystal.

In any of the cases of the infrared LED elements 1, 1a, and 1b of the embodiments described above, the second light-emitting layer 42 is formed after the laminate for tunnel junction 30 is formed. Therefore, when the quality of the crystal of the laminate for tunnel junction 30 reduces, the quality of the second light-emitting layer 42 to be formed by crystal growth thereafter reduces, which may result in reduced light-emitting efficiency and reliability. Further, when the crystal of the laminate for tunnel junction 30 deteriorates, a voltage may conversely increase even though the laminate for tunnel junction 30 is doped at a high concentration.

Particularly, it is known that InP has a lower injectable maximum dopant concentration as compared to GaAs widely used for elements having a peak emission wavelength of 1000 nm or less. Particularly, the maximum dopant concentration of p-type InP is about three orders of magnitude lower than that of p-type GaAs. From such a viewpoint, the present inventors considered that it would be difficult to achieve a tunnel layer in an infrared LED element with a peak emission wavelength of 1000 nm or more, which is formed using a material that can be lattice-matched to an InP single crystal. In fact, before the filing of the present application, InP-based infrared LED elements having a tunnel junction layer have been unknown.

However, as can be seen from the results shown in Fig. 11 and Fig. 13, also in the case of the infrared LED element achieved using a material that can be lattice-matched to an InP single crystal and having a peak emission wavelength of 1000 nm or more, optical output can be improved and a tunnel junction can be achieved. This is a new finding obtained as a result of intensive studies by the present inventors.

### (Verification 2)

Then, the infrared LED elements 1 of the first embodiment different in the compositions of the first tunnel layer 31 and the second tunnel layer 32 were prepared as samples to measure a forward voltage necessary to inject the same amount of electric current. The results are shown in Table 1.

**[Table 1]**

| Second tunnel layer 32 (n-type) | | First tunnel layer 31 (p-type) | | Forward voltage (V) at 50 mA |
|---|---|---|---|---|
| Composition | Wavelength corresponding to band gap [nm] | Composition | Wavelength corresponding to band gap [nm] | |
| InP | 960 | InP | 960 | 3.5 V |
| InP | 960 | Ga_{0.15}In_{0.85}As_{0.33}P_{0.67} | 1100 | 2.7 V |
| Ga_{0.15}In_{0.85}As_{0.33}P_{0.67} | 1100 | InP | 960 | 2.4 V |
| Ga_{0.15}In_{0.85}As_{0.33}P_{0.67} | 1100 | Ga_{0.15}In_{0.85}As_{0.33}P_{0.67} | 1100 | 2.6 V |
| Ga_{0.22}In_{0.78}As_{0.48}P_{0.52} | 1200 | Ga_{0.15}In_{0.85}As_{0.33}P_{0.67} | 1100 | 2.4 V |

As can be seen from Table 1, as compared to when both the first tunnel layer 31 and the second tunnel layer 32 are made of InP, a forward voltage can be reduced when Ga and As are contained in at least one selected from the first tunnel layer 31 and the second tunnel layer 32. Furthermore, comparing the first tunnel layer 31 and the second tunnel layer 32, it is confirmed that the forward voltage can be further reduced by increasing the Ga and As compositions of the second tunnel layer 32, which is n-type, compared to the first tunnel layer 31, which is p-type.

Increasing the Ga composition and the As composition of a material for forming a tunnel layer corresponds to reducing a band gap energy, that is, making a wavelength corresponding to a band gap longer. That is, it can be seen that an infrared LED element having high optical output while achieving a reduction in forward voltage can be achieved by selecting materials of the first tunnel layer 31 and the second tunnel layer 32 so that a wavelength corresponding to a band gap of a material constituting the n-type second tunnel layer 32 is longer than a wavelength corresponding to a band gap of a material constituting the p-type first tunnel layer 31.

### (Verification 3)

The infrared LED elements 1 of the first embodiment having the p-type first tunnel layer 31 made of InP and the n-type second tunnel layer 32 made of GalnAsP were prepared as samples different in the dopant concentration of each of the tunnel layers to measure a forward voltage necessary to inject the same amount of electric current. The results are shown in Fig. 14A and Fig. 14B.

Fig. 14A is a graph showing a trend of change in forward voltage when the dopant concentration (Si concentration) of the n-type second tunnel layer 32 is fixed at 1 × 10¹⁹/cm³ and the dopant concentration (Zn concentration) of the p-type first tunnel layer 31 is changed. As can be seen from Fig. 14A, the forward voltage tends to slightly reduce as the dopant concentration of the p-type first tunnel layer 31 increases.

Fig. 14B is a graph showing a trend of change in forward voltage when the dopant concentration (Zn concentration) of the p-type first tunnel layer 31 is fixed at 7.5 × 10¹⁸/cm³ and the dopant concentration (Si concentration) of the n-type second tunnel layer 32 is changed. As can be seen from Fig. 14B, the forward voltage tends to increase as the dopant concentration of the n-type second tunnel layer 32 increases. The reason why such a phenomenon occurs is not clear, but it is inferred that one of the causes for this is a reduction in crystallinity such as an increase in the amount of strain of a semiconductor crystal due to an extremely high concentration of an impurity-doped to form a tunnel layer.

## Claims

1. An infrared LED element (1) having a peak emission wavelength of 1000 nm or more, the infrared LED element (1) comprising:
a first LED laminate (20) including a first cladding layer (21) of a first conductivity type being p-type or n-type, a first light-emitting layer (22) disposed directly or indirectly on top of the first cladding layer (21), and a second cladding layer (23) of a second conductivity type different from the first conductivity type, the second cladding layer (23) being disposed directly or indirectly on top of the first light-emitting layer (22);
a laminate for tunnel junction (30) disposed directly or indirectly on top of the first LED laminate (20); and
a second LED laminate (40) including a third cladding layer (41) of the first conductivity type disposed directly or indirectly on top of the laminate for tunnel junction (30), a second light-emitting layer (42) directly or indirectly disposed on top of the third cladding layer (41), and a fourth cladding layer (43) of the second conductivity type disposed directly or indirectly on top of the second light-emitting layer (42),
wherein the laminate for tunnel junction (30) includes:
a first tunnel layer (31) disposed directly or indirectly on top of the second cladding layer (23) and containing a dopant of the second conductivity type at a higher concentration than the second cladding layer (23); and
a second tunnel layer (32) disposed directly or indirectly on top of the first tunnel layer (31) and below the third cladding layer (41), containing a dopant of the first conductivity type at a higher concentration than the third cladding layer (41), and forming a tunnel junction with the first tunnel layer (31), and
the first light-emitting layer (22), the second light-emitting layer (42), the first tunnel layer (31), and the second tunnel layer (32) are made of a material that can be lattice-matched to an InP single crystal.

2. The infrared LED element (1) according to claim 1, wherein the first tunnel layer (31) and the second tunnel layer (32) are made of a material having a band gap corresponding to a wavelength shorter than the peak emission wavelength.

3. The infrared LED element (1) according to claim 1 or 2, wherein at least one selected from the first tunnel layer (31) and the second tunnel layer (32) is made of a material containing Ga and As.

4. The infrared LED element (1) according to claim 3, wherein
the first conductivity type is an n type, the second conductivity type is a p type, and
a wavelength corresponding to a band gap of a material constituting the second tunnel layer (32) is longer than a wavelength corresponding to a band gap of a material constituting the first tunnel layer (31).

5. The infrared LED element (1) according to claim 4, wherein a Ga composition of a material constituting the second tunnel layer (32) is higher than a Ga composition of a material constituting the first tunnel layer (31).

6. The infrared LED element (1) according to claim 4, wherein an As composition of a material constituting the second tunnel layer (32) is higher than an As composition of a material constituting the first tunnel layer (31).

7. The infrared LED element (1) according to claim 1 or 2, wherein
the first light-emitting layer (22) and the second light-emitting layer (42) are made of materials different in composition and
a peak wavelength of light generated by one of the first light-emitting layer (22) and the second light-emitting layer (42), which is located closer to a light extraction surface, is longer than that of light generated by the other light-emitting layer.
